# EUROPEAN PATENT APPLICATION

(11) **EP 4 766 114 A1**
(43) Date of publication of application: **24.06.2026**
(21) Application number: 23962584.1
(22) Date of filing: 26.12.2023
(51) Int. Cl.: H10K 59/122, H10K 50/19, H10K 50/13

(54) **DISPLAY SUBSTRATE, DISPLAY PANEL, AND DISPLAY DEVICE**

(71) Applicant: Boe Technology Group Co., Ltd., Beijing 100015 (CN); Yunnan Invensight Optoelectronics Technology Co., Ltd., Kunming, Yunnan 650211 (CN); Beijing BOE Technology Development Co., Ltd., Daxing District Beijing 100176 (CN)
(72) Inventor: WU, Cao, Beijing 100176 (CN); LEE, Yuhao, Beijing 100176 (CN); HUANG, Yinhu, Beijing 100176 (CN); WANG, Huanhuan, Beijing 100176 (CN); SHEN, Xiaobin, Beijing 100176 (CN); SU, Dongdong, Beijing 100176 (CN); FENG, Bingming, Beijing 100176 (CN); CAI, Qinshan, Beijing 100176 (CN); MA, Siyuan, Beijing 100176 (CN); LI, Guiqin, Beijing 100176 (CN); JIN, Shiyu, Beijing 100176 (CN); ZHANG, Dacheng, Beijing 100176 (CN)
(74) Representative: AWA Sweden AB
(86) International application number: PCT/CN2023/142114
(87) International publication number: WO 2025/137890

(57) **Abstract**

Provided are a display substrate, a display panel and a display device. The display substrate includes a base substrate, a pixel definition layer, a light-emitting functional layer and a second electrode layer arranged sequentially. The light-emitting functional layer includes a charge generation layer. The pixel definition layer defines pixel openings. The pixel definition layer includes a pixel definition portion having an undercut structure on a side facing the pixel opening. The undercut structure includes first, second and third portions, the second portion recesses a first distance relative to the third portion in a direction away from the pixel opening, and the first portion protrudes a second distance relative to the third portion in a direction toward the pixel opening. A virtual connecting line between edges of the first portion and the third portion facing the pixel opening forms a first slope angle with a first direction. Above the undercut structure, the second electrode layer includes a second electrode second sub-portion whose side edge facing the pixel opening has a second slope angle, and the first slope angle is less than the second slope angle.

## Description

### TECHNICAL FIELD

The present disclosure relates to the field of display technology, and in particular, to a display substrate, a display panel and a display device.

### BACKGROUND

Silicon-based OLED (Organic Light-Emitting Diode) is a micro-display developed in recent years. Through a mature silicon-based semiconductor process, it is possible to fabricate an OLED display with high PPI (pixel density) and high refresh rate, which may be applied to fields of VR (Virtual Reality) and AR (Augmented Reality). Silicon-based OLED may achieve a colorization of display by means of white light + three-color filtering, and achieve an effect of luminous superposition by using a CGL (charge generation layer) connected in series with a plurality of light-emitting layers. In the related art, a display panel includes a plurality of pixel units to achieve a high PPI display effect. However, due to an accuracy limitation of a traditional FMM (fine metal mask), adjacent pixel units need to be partitioned by a pixel partitioning process.

How to minimize a leakage between pixels while achieving an effective partition between pixels so as to ensure power consumption and life of a display substrate is one of important research topics for R&D personnel.

It should be noted that the above information disclosed in this section is just for understanding of the background of the present disclosure. Therefore, the above information may include information that does not constitute the related art known to those skilled in the art.

### SUMMARY

In an aspect, a display substrate is provided, including: a base substrate; a pixel definition layer provided on the base substrate, the pixel definition layer has a plurality of pixel openings, the plurality of pixel openings define a plurality of sub-pixels arranged in an array in a first direction and a second direction, the pixel definition layer includes a pixel definition portion located between two adjacent pixel openings, the pixel definition portion has an undercut structure on a side facing the pixel opening, the undercut structure includes a first portion, a second portion and a third portion, the first portion is located on a side of the second portion close to the base substrate and protrudes a second distance relative to the third portion in a direction toward the pixel opening, the third portion is located on a side of the second portion away from the base substrate, and the second portion recesses a first distance relative to the third portion in a direction away from the pixel opening; a light-emitting functional layer provided on a side of the pixel definition layer away from the base substrate, the light-emitting functional layer includes a charge generation layer; and a second electrode layer provided on a side of the light-emitting functional layer away from the base substrate, the second electrode layer includes a second electrode second sub-portion, an orthographic projection of the second electrode second sub-portion on the base substrate overlaps at least partially with an orthographic projection of the undercut structure on the base substrate, and the second electrode layer extends continuously at the undercut structure. A virtual connecting line between an edge of the first portion in a direction facing the pixel opening and an edge of the third portion in a direction facing the pixel opening forms a first slope angle with the first direction, a side edge of the second electrode second sub-portion in a direction facing the pixel opening has a second slope angle, and the first slope angle is less than the second slope angle.

According to some exemplary embodiments, the first slope angle is less than 30°; and/or the second distance is greater than twice the first distance.

According to some exemplary embodiments, the edge of the first portion in the direction facing the pixel opening has a third slope angle, the edge of the third portion in the direction facing the pixel opening has a fourth slope angle, and the third slope angle is less than the fourth slope angle.

According to some exemplary embodiments, a side edge of the second electrode second sub-portion in a direction away from the pixel opening has a fifth slope angle, and the fifth slope angle is less than the first slope angle.

According to some exemplary embodiments, the pixel definition layer includes a first pixel definition sub-layer, a second pixel definition sub-layer and a third pixel definition sub-layer sequentially stacked in a direction away from the base substrate; and the first portion is located in the first pixel definition sub-layer, the second portion is located in the second pixel definition sub-layer, and the third portion is located in the third pixel definition sub-layer.

According to some exemplary embodiments, the display substrate further includes a first electrode layer provided on a side of the pixel definition layer close to the base substrate; the display substrate includes a plurality of first electrodes in the first electrode layer, the plurality of first electrodes are arranged in an array in the first direction and the second direction, and orthographic projections of the plurality of pixel openings on the base substrate fall within orthographic projections of the plurality of first electrodes on the base substrate, respectively; and the pixel definition portion further includes a pixel definition body portion and a lap portion, an orthographic projection of the pixel definition body portion on the base substrate is located between orthographic projections of two adjacent first electrodes on the base substrate, an orthographic projection of the lap portion on the base substrate overlaps with the orthographic projection of the first electrode on the base substrate, and the lap portion protrudes relative to the pixel definition body portion in a direction away from the base substrate.

According to some exemplary embodiments, the display substrate further includes a plurality of third electrodes electrically connected to the first electrodes, an orthographic projection of the third electrode on the base substrate overlaps at least partially with the orthographic projection of the pixel definition body portion on the base substrate, the third electrode protrudes relative to the first electrode in a direction close to the base substrate, the third electrode protrudes a third distance relative to the first electrode in the direction away from the pixel opening, and the third distance is greater than the second distance.

According to some exemplary embodiments, a side edge of the second portion in a direction facing the pixel opening has a sixth slope angle, a side edge of the lap portion in a direction away from the pixel opening has a seventh slope angle, and a side edge of the pixel definition body portion in a direction facing the pixel opening has an eighth slope angle; the sixth slope angle is greater than the seventh slope angle; and/or the seventh slope angle is greater than the first slope angle; and/or the first slope angle is greater than the eighth slope angle.

According to some exemplary embodiments, the first portion, the second portion and the third portion are located on a side of the lap portion facing the pixel opening, and a surface of the second portion facing the pixel opening is a curved surface concave toward the pixel definition body portion.

According to some exemplary embodiments, the plurality of sub-pixels include a first sub-pixel and a second sub-pixel adjacent to each other in the first direction or the second direction, the first sub-pixel includes a first pixel opening, and the second sub-pixel includes a second pixel opening; and the pixel definition portion includes a pixel definition portion located between the first pixel opening and the second pixel opening, the pixel definition portion has undercut structures on a first side facing the first pixel opening and a second side facing the second pixel opening, and the charge generation layer is disconnected at the undercut structures.

According to some exemplary embodiments, the display substrate includes a first charge generation sub-portion, a second charge generation sub-portion and a third charge generation sub-portion in the charge generation layer, an orthographic projection of the first charge generation sub-portion on the base substrate overlaps at least partially with an orthographic projection of the first pixel opening on the base substrate, an orthographic projection of the second charge generation sub-portion on the base substrate overlaps at least partially with an orthographic projection of the second pixel opening on the base substrate, and an orthographic projection of the third charge generation sub-portion on the base substrate overlaps at least partially with an orthographic projection of the pixel definition portion on the base substrate; and the first charge generation sub-portion is disconnected from the third charge generation sub-portion at the undercut structure on the first side of the pixel definition portion, and the second charge generation sub-portion is disconnected from the third charge generation sub-portion at the undercut structure on the second side of the pixel definition portion.

According to some exemplary embodiments, the light-emitting functional layer includes a first light-emitting sub-layer and a second light-emitting sub-layer, the first light-emitting sub-layer is located between the first electrode layer and the charge generation layer, and the second light-emitting sub-layer is located on a side of the charge generation layer away from the base substrate; the first light-emitting sub-layer is configured to generate light having a first wavelength, and the second light-emitting sub-layer is configured to generate light having a second wavelength; and the light having the first wavelength includes yellow light or red-green mixed light; and/or the light having the second wavelength includes blue light.

According to some exemplary embodiments, any two of an orthographic projection of the second light-emitting sub-layer on the base substrate, an orthographic projection of the first charge generation sub-portion on the base substrate and an orthographic projection of the first portion of the undercut structure on the first side of the pixel definition portion on the base substrate overlap at least partially with each other; and/or any two of the orthographic projection of the second light-emitting sub-layer on the base substrate, an orthographic projection of the second charge generation sub-portion on the base substrate and an orthographic projection of the first portion of the undercut structure on the second side of the pixel definition portion on the base substrate overlap at least partially with each other.

According to some exemplary embodiments, the second pixel definition sub-layer has a second thickness in a third direction, the third pixel definition sub-layer has a third thickness in the third direction, a maximum distance between a surface of the first charge generation sub-portion away from the base substrate or a surface of the second charge generation sub-portion away from the base substrate and a surface of the first electrode layer away from the base substrate is a first height, the third direction is perpendicular to the first direction and the second direction, and a sum of the second thickness and the third thickness is greater than the first height.

According to some exemplary embodiments, the second distance is greater than a sum of the second thickness, the third thickness and 0.5 times the first distance, and the sum of the second thickness, the third thickness and 0.5 times the first distance is greater than 1100 angstroms.

According to some exemplary embodiments, the first distance is greater than or equal to 400 angstroms and less than or equal to 600 angstroms.

According to some exemplary embodiments, the second thickness is greater than or equal to 300 angstroms and less than or equal to 600 angstroms; and/or the third thickness is greater than or equal to 200 angstroms.

According to some exemplary embodiments, the first pixel definition sub-layer has a first thickness in a third direction, and the first thickness is greater than or equal to 200 angstroms and less than or equal to 300 angstroms.

According to some exemplary embodiments, the third electrode has a fourth thickness in the third direction, and the first thickness is less than the fourth thickness.

According to some exemplary embodiments, a side edge of the lap portion in a direction away from the pixel opening has a fifth thickness, and the fifth thickness is less than a sum of the first thickness, the second thickness and the third thickness.

According to some exemplary embodiments, the second distance is greater than 0.15 microns.

According to some exemplary embodiments, the third charge generation sub-portion includes a first sub-portion and a second sub-portion, an orthographic projection of the first sub-portion on the base substrate overlaps at least partially with an orthographic projection of the pixel definition body portion on the base substrate, and an orthographic projection of the second sub-portion on the base substrate overlaps at least partially with either an orthographic projection of the lap portion on the base substrate or an orthographic projection of the third portion on the base substrate; and in a third direction, a maximum distance between a surface of the first sub-portion away from the base substrate and a surface of the first electrode layer away from the base substrate is a second height, a maximum distance between a surface of the second sub-portion away from the base substrate and the surface of the first electrode layer away from the base substrate is a third height, and the third height is greater than the second height.

According to some exemplary embodiments, the second height is greater than a first height, and a height difference between the third height and the second height is greater than a height difference between the second height and the first height.

According to some exemplary embodiments, the second electrode layer further includes a second electrode first sub-portion and a second electrode third sub-portion, an orthographic projection of the second electrode first sub-portion on the base substrate overlaps at least partially with an orthographic projection of a first electrode on the base substrate, an orthographic projection of the second electrode second sub-portion on the base substrate overlaps at least partially with an orthographic projection of a lap portion on the base substrate, and an orthographic projection of the second electrode third sub-portion on the base substrate overlaps at least partially with an orthographic projection of a pixel definition body portion on the base substrate; and in a third direction, a maximum distance between a surface of the second electrode first sub-portion away from the base substrate and a surface of a first electrode layer away from the base substrate is a fourth height, a maximum distance between a surface of the second electrode second sub-portion away from the base substrate and the surface of the first electrode layer away from the base substrate is a fifth height, a maximum distance between a surface of the second electrode third sub-portion away from the base substrate and the surface of the first electrode layer away from the base substrate is a sixth height, the fifth height is greater than the sixth height, and the sixth height is greater than the fourth height.

According to some exemplary embodiments, a height difference between the fifth height and the sixth height is greater than a height difference between the sixth height and the fourth height.

According to some exemplary embodiments, the first pixel definition sub-layer contains SiOx; and/or the second pixel definition sub-layer contains SiNx; and/or the third pixel definition sub-layer contains SiOx; and/or the second electrode layer contains IZO.

In another aspect, a display panel is provided, including the display substrate described above.

In yet another aspect, a display device is provided, including the display substrate or the display panel described above.

### BRIEF DESCRIPTION OF THE DRAWINGS

Through the following descriptions of the present disclosure with reference to the accompanying drawings, other objectives, features and advantages of the present disclosure will be clearer. In the accompanying drawings:
FIG. 1 shows a schematic partial plan view of a display substrate according to the embodiments of the present disclosure;
FIG. 2 shows a schematic cross-sectional view of a display substrate according to the embodiments of the present disclosure taken along line AA' of FIG. 1;
FIG. 3A shows a schematic cross-sectional view of a display substrate according to some embodiments of the present disclosure taken along line BB' of FIG. 1;
FIG. 3B shows a schematic cross-sectional view of a display substrate according to some other embodiments of the present disclosure taken along line BB' of FIG. 1;
FIG. 4 shows a simulated relationship diagram of a blue light spectrum and a first thickness of a first portion of a display substrate according to some embodiments of the present disclosure;
FIG. 5A and FIG. 5B respectively show schematic diagrams of evaporation effects on a display substrate according to some embodiments of the present disclosure;
FIG. 6A and FIG. 6B respectively show comparison diagrams of distortions of display substrates according to some embodiments of the present disclosure;
FIG. 7 shows a schematic cross-sectional view of a display substrate according to some other embodiments of the present disclosure taken along line CC' of FIG. 1;
FIG. 8 shows a schematic structural diagram of a display panel provided according to some embodiments of the present disclosure; and
FIG. 9 shows a schematic structural diagram of a display device provided according to some embodiments of the present disclosure.

It should be noted that for the sake of clarity, in the accompanying drawings used to describe the embodiments of the present disclosure, sizes of layers, structures or regions may be enlarged or reduced, that is, these accompanying drawings are not drawn according to actual scale.

### DETAILED DESCRIPTION OF EMBODIMENTS

In order to make objectives, technical solutions and advantages of the embodiments of the present disclosure clearer, technical solutions of the embodiments of the present disclosure will be clearly and completely described below with reference to the accompanying drawings. Obviously, the described embodiments are just some embodiments rather than all embodiments of the present disclosure. Based on the described embodiments of the present disclosure, all additional embodiments obtained by those ordinary skilled in the art without carrying out inventive effort fall within the scope of protection of the present disclosure.

It should be noted that in the accompanying drawings, for clarity and/or description purposes, a size and relative size of an element may be enlarged. Accordingly, the size and relative size of each element need not to be limited to those shown in the drawings. In the specification and the accompanying drawings, the same or similar reference numerals represent the same or similar components.

Unless otherwise defined, the technical or scientific terms used in the present disclosure should have the general meanings understood by those skilled in the art. The words "first", "second" and the like used in the present disclosure do not indicate any order, quantity or importance, but are just used to distinguish different compositions. The word "including", "comprising" or the like means that an element or object preceding that word includes elements or objects and their equivalents listed after that word, but does not exclude other elements or objects.

Herein, unless otherwise specified, directional terms such as "upper", "lower", "left", "right", "inside", "outside", etc. are used to indicate orientations or positional relationships shown based on the accompanying drawings, which are intended to facilitate descriptions of the present disclosure and not to indicate or imply that the device, element or component referred to must have a specific orientation or must be constructed or operated in a specific orientation. It should be understood that when an absolute position of a described object changes, the relative positional relationships indicated by the terms may also change accordingly. Therefore, these directional terms may not be understood as limitations to the present disclosure.

It should be noted that the expression "a same layer" herein refers to a layer structure that is formed by firstly forming, using a same film forming process, a film layer used to form a specific pattern, and then patterning, using one-time patterning process, the film layer with a same mask. Depending on different specific patterns, the one-time patterning process may include a plurality of exposure, development or etching processes, and the specific pattern in the formed layer structure may be continuous or discontinuous. That is, a plurality of elements, components, structures and/or portions located in "a same layer" are made of the same material and formed by the same patterning process. Generally, a plurality of elements, components, structures and/or portions located in "the same layer" have substantially the same thickness.

Those skilled in the art should understand that, unless otherwise specified, the expression "height" or "thickness" herein refers to a size in a direction perpendicular to a surface of each film layer provided on a display substrate, that is, a size in a light emitting direction of the display substrate, or referred as a size in a normal direction of a display device.

Herein, the directional expressions "first direction" and "second direction" are used to describe different directions along a pixel unit, e.g., a longitudinal direction and a transverse direction of the pixel unit, or a row direction and a column direction of an arrangement of sub-pixels. It should be understood that such expressions are just exemplary descriptions and not limitations to the present disclosure.

A brief description of the technical terms involved in the present disclosure will be provided below for a better understanding of the present disclosure.

Transfer rate: a transfer rate refers to a ratio of a luminous efficiency of a display substrate to a luminous efficiency of a reference light-emitting device formed in a same process. An anode of the reference light-emitting device is a whole surface electrode, a cathode of the reference light-emitting device is also a whole surface electrode, and the reference light-emitting device is an integral light-emitting unit, which may exclude an interference of electrical leakage and other factors on the luminous efficiency of the reference light-emitting device. A transfer rate indicator may be used to measure an electrical leakage between pixel units in the display substrate, the higher the transfer rate, the lower an electrical leakage level between pixel units.

Distortion: due to a large height difference at a partition structure, an evaporation material film layer in an OLED device may undergo a rapid change in film morphology at the partition structure, which may result in a distortion. There is a high probability of electrical leakage at the distortion.

Some exemplary embodiments of the present disclosure provide a display substrate, including: a base substrate; a pixel definition layer provided on the base substrate; a light-emitting functional layer provided on a side of the pixel definition layer away from the base substrate, where the light-emitting functional layer includes a charge generation layer. The pixel definition layer has a plurality of pixel openings, and the plurality of pixel openings define a plurality of sub-pixels arranged in an array in a first direction and a second direction. The pixel definition layer includes a pixel definition portion located between two adjacent pixel openings, and the pixel definition portion has an undercut structure on a side facing the pixel opening. The undercut structure includes a first portion, a second portion and a third portion, the first portion is located on a side of the second portion close to the base substrate and protrudes a second distance relative to the third portion in a direction toward the pixel opening; the third portion is located on a side of the second portion away from the base substrate, and the second portion recesses a first distance relative to the third portion in a direction away from the pixel opening. The display substrate further includes a second electrode layer provided on a side of the light-emitting functional layer away from the base substrate, and the second electrode layer includes a second electrode second sub-portion. An orthographic projection of the second electrode second sub-portion on the base substrate overlaps at least partially with an orthographic projection of the undercut structure on the base substrate, and the second electrode layer extends continuously at the undercut structure. A virtual connecting line between an edge of the first portion in a direction facing the pixel opening and an edge of the third portion in a direction facing the pixel opening forms a first slope angle with the first direction, a side edge of the second electrode second sub-portion in a direction facing the pixel opening has a second slope angle, and the first slope angle is less than the second slope angle. Through the design of the pixel definition portion having a plurality of undercut structures among the pixel openings, it is possible to reduce a height of the pixel definition portion while ensuring an effective partition between pixels, so that an electron transport layer and a cathode may have smooth morphologies, the electrical leakage between pixels may be reduced, the transfer rate of the light-emitting device may be improved, an in-plane uniformity of the display substrate may be improved, and a better display effect may be achieved.

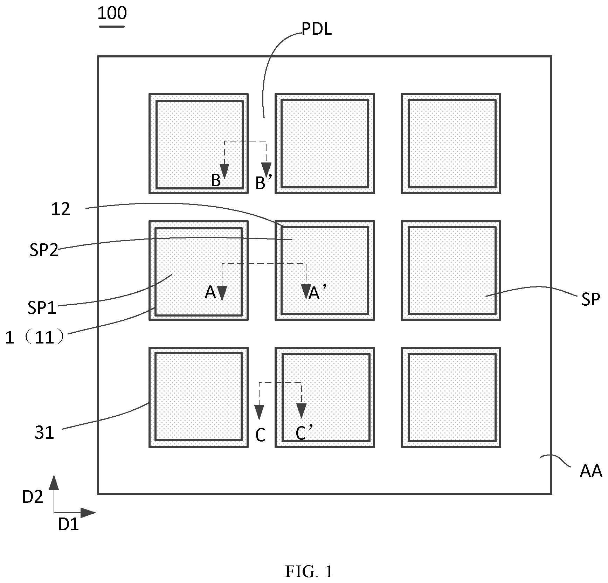

FIG. 1 shows a schematic partial plan view of a display substrate according to the embodiments of the present disclosure.

For example, in some embodiments of the present disclosure, referring to FIG. 1, a display substrate 100 includes a display region AA and a plurality of sub-pixels SP located in the display region AA. The plurality of sub-pixels are arranged in an array in a first direction D1 and a second direction D2, and the plurality of sub-pixels include a first sub-pixel SP1 and a second sub-pixel SP2 adjacent to each other in the first direction D1 or the second direction D2. The display substrate 100 further includes a pixel definition layer PDL having a plurality of pixel openings 1, and the plurality of pixel openings 1 define a plurality of sub-pixels SP. For example, the first sub-pixel SP1 includes a first pixel opening 11, and the second sub-pixel SP2 includes a second pixel opening 12. A pixel opening may be an opening region that includes a light-emitting region.

It should be noted that the embodiments of the present disclosure do not particularly limit a design of the pixel opening 1. For example, the pixel opening 1 is schematically shown as a square, but in other embodiments, the pixel opening may also be a rectangle, an ellipse, a circle, a triangle or other shapes. In addition, the light-emitting units having different colors corresponding to different pixel openings may be arranged in various ways known in the art, which is not particularly limited in the embodiments of the present disclosure.

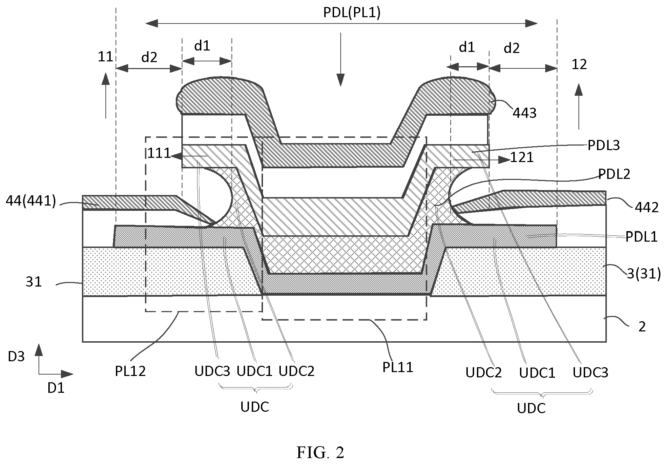

FIG. 2 shows a schematic cross-sectional view of the display substrate according to the embodiments of the present disclosure taken along line AA' of FIG. 1.

For example, in some embodiments of the present disclosure, referring to FIG. 1 and FIG. 2 in combination, the display substrate 100 includes a base substrate 2 and a first electrode layer 3 provided on the base substrate 2. The first electrode layer includes a plurality of first electrodes 31 arranged in an array in the first direction D1 and the second direction D2. Orthographic projections of the plurality of pixel openings 1 on the base substrate 2 fall within orthographic projections of the plurality of first electrodes 31 on the base substrate 2, respectively. That is to say, the plurality of first electrodes 31 respectively correspond to the plurality of sub-pixels SP in terms of position, and an area of the first electrode is greater than a light-emitting area of the sub-pixel.

For example, continuing to refer to FIG 2, the pixel definition layer PDL is located on a side of the first electrode layer 3 away from the base substrate. The pixel definition layer PDL includes a pixel definition portion PL1 located between the first pixel opening 11 and the second pixel opening 12, and the pixel definition portion PL1 has undercut structures UDC on a first side 111 facing the first pixel opening 11 and a second side 121 facing the second pixel opening 12. The display substrate further includes a light-emitting functional layer provided on a side of the pixel definition layer away from the base substrate 2, and the light-emitting functional layer includes a charge generation layer 44. The charge generation layer 44 is disconnected at the undercut structure UDC.

In a stacked OLED device, due to a high conductivity of the charge generation layer 44, when the charge generation layer between adjacent pixels is not partitioned, it is easy to cause lateral crosstalk between pixels. By designing the undercut structures at two ends of the pixel definition portion, the charge generation layer between adjacent pixels may be disconnected at the undercut structures, thereby reducing the lateral crosstalk between pixels and improving the display effect of the display substrate.

For example, in some embodiments of the present disclosure, continuing to refer to FIG. 2, the undercut structure UDC includes a first portion UDC1, a second portion UDC2 and a third portion UDC3. The third portion UDC3 is located on a side of the second portion UDC2 away from the base substrate 2, and the second portion UDC2 recesses a first distance d1 relative to the third portion UDC3 in a direction away from the pixel opening. The first portion UDC1 protrudes a second distance d2 relative to the third portion UDC3 in a direction toward the pixel opening. For example, on a side of the pixel definition portion PL1 close to the pixel opening 11, the second portion UDC2 recesses the first distance d1 relative to the third portion UDC3 in a direction away from the pixel opening 11, and the first portion UDC 1 protrudes the second distance d2 relative to the third portion UDC3 in a direction toward the pixel opening 11. On a side of the pixel definition portion PL1 close to the pixel opening 12, the second portion UDC2 recesses the first distance d1 relative to the third portion UDC3 in a direction away from the pixel opening 12, and the first portion UDC1 protrudes the second distance d2 relative to the third portion UDC3 in a direction toward the pixel opening 12. For example, in some embodiments of the present disclosure, the undercut structures on two sides of the pixel definition portion each include a stacked structure of the first portion UDC1, the second portion UDC2 and the third portion UDC3, where the second portion UDC2 is concave relative to the first portion UDC1 and the third portion UDC3. The undercut structures on the two sides may be the same as or different from each other. For example, the second distance that the first portion UDC1 of the UDC structure on a side close to the opening 11 protrudes relative to the third portion UDC3 in the direction toward the pixel opening may be the same as or different from the second distance that the first portion UDC1 of the UDC structure on a side close to the opening 12 protrudes relative to the third portion UDC3 in the direction toward the pixel opening. Recessing depths of the second portions UDC2 of the undercut structures UDC on the two sides may also be the same as or different from each other.

By designing the undercut structures on the two sides of the pixel definition portion as structures with two protruding ends and a concave middle, it is possible to reduce a required height of the pixel definition layer while ensuring the effective partition of the charge generation layer, so that film layers such as a cathode layer located above the pixel definition layer may be smoother at an edge of the undercut structure, thereby improving an uniformity of an electric field distribution in the pixel and reducing stray light at the edge.

For example, in some embodiments of the present disclosure, continuing to refer to FIG. 2, the pixel definition layer PDL may include a plurality of pixel definition sub-layers provided in a stack. For example, the pixel definition layer PDL may include a first pixel definition sub-layer PDL1, a second pixel definition sub-layer PDL2 and a third pixel definition sub-layer PDL3 that are sequentially stacked in a direction away from the base substrate 2. The first portion UDC1 is located in the first pixel definition sub-layer PDL1, the second portion UDC2 is located in the second pixel definition sub-layer PDL2, and the third portion UDC3 is located in the third pixel definition sub-layer PDL3.

The plurality of pixel definition sub-layers may be made of a same or different materials. For example, the first pixel definition sub-layer PDL1 may contain SiOₓ; and/or the second pixel definition sub-layer PDL2 may contain SiNₓ; and/or the third pixel definition sub-layer PDL3 may contain SiOₓ. The plurality of pixel definition sub-layers may have different etching rates under a same etching process condition. For example, the etching rate of the second pixel definition sub-layer may be higher than the etching rate of the third pixel definition sub-layer, so that a concave structure of the second portion UDC2 recessing relative to the third portion UDC3 in the direction away from the pixel opening may be formed in the etching process. By forming the pixel definition portion with undercut structures, it is possible to effectively partition the charge generation layer, reduce the lateral crosstalk between pixels, reduce an electrical leakage rate, improve the transfer rate of the display substrate, and improve the display effect of the display substrate.

For example, continuing to refer to FIG. 2, the pixel definition portion PL1 further includes a pixel definition body portion PL11 and a lap portion PL12. An orthographic projection of the pixel definition body portion PL11 on the base substrate 2 is located between orthographic projections of two adjacent first electrodes 31 on the base substrate 2, and an orthographic projection of the lap portion PL12 on the base substrate 2 overlaps with the orthographic projection of the first electrode 31 on the base substrate 2. The lap portion PL12 protrudes relative to the pixel definition body portion PL11 in a direction away from the base substrate 2.

For example, in some embodiments of the present disclosure, the first portion UDC1, the second portion UDC2 and the third portion UDC3 are all located on a side of the lap portion PL12 facing the pixel opening. A surface of the second portion UDC2 facing the pixel opening 1 is a curved surface recessing toward the pixel definition body portion PL11.

Due to a large height difference between the lap portion PL12 and the first electrode 31 in a third direction D3 and the lap portion PL12 includes a concave curved surface in the middle, the charge generation layer 44 is prone to film breakage in a vicinity of the lap portion PL12, so that a purpose of disconnecting the charge generation layer and reducing the lateral crosstalk between pixels may be achieved. The third direction D3 is perpendicular to both the first direction D1 and the second direction D2.

For example, in some embodiments of the present disclosure, continuing to refer to FIG. 2, the display substrate 100 includes a first charge generation sub-portion 441, a second charge generation sub-portion 442 and a third charge generation sub-portion 443 that are located in the charge generation layer 44. An orthographic projection of the first charge generation sub-portion 441 on the base substrate overlaps at least partially with an orthographic projection of the first pixel opening 11 on the base substrate, an orthographic projection of the second charge generation sub-portion 442 on the base substrate overlaps at least partially with an orthographic projection of the second pixel opening 12 on the base substrate, and an orthographic projection of the third charge generation sub-portion 443 on the base substrate overlaps at least partially with an orthographic projection of the pixel definition portion PL1 on the base substrate. In other words, the charge generation layer between two adjacent pixels may form three different sub-portions due to the partition of the pixel definition portion. The first charge generation sub-portion 441 is disconnected from the third charge generation sub-portion 443 at the undercut structure on the first side 111 of the pixel definition portion, and the second charge generation sub-portion 442 is disconnected from the third charge generation sub-portion 443 at the undercut structure on the second side 121 of the pixel definition portion.

By designing the undercut structures on the two sides of the pixel definition portion, the charge generation layers located above the pixel opening regions on the two sides of the pixel definition portion may be effectively disconnected from the charge generation layer located above the pixel definition portion, which may avoid an occurrence of lateral electrical leakage between some pixel units and the charge generation layer above the pixel definition portion, and thus avoid an uneven luminescence of the display substrate.

For example, in some embodiments of the present disclosure, the display substrate may include a silicon-based OLED display substrate. The Silicon-based OLED may achieve colorization of display by means of white light + three-color filtering. A white OLED may typically include a plurality of stacked light-emitting layers, and different light-emitting layers may generate different colors of light. Different colors of light may be mixed to form the white light, and the white light formed by mixing may be combined with a filter structure so as to achieve an effect of color display. For example, different light-emitting layers may include a yellow light-emitting layer and a blue light-emitting layer, or a red-green mixed light-emitting layer and a blue light-emitting layer. It is possible to achieve white light by mixing yellow light with blue light, or mixing red-green mixed light with blue light. However, due to different lighting voltages and different luminous efficiencies of light-emitting layers having different colors in a stacked device, the color of mixed light is prone to a color shift with a change of voltage under different external electric fields, thereby reducing the display effect. For example, the lighting voltage of blue light is higher than the lighting voltage of yellow light or red-green light, and in a case of low grayscale display, due to a low voltage of the external electric field, there may be cases where the blue light-emitting layer is not lit up or a brightness of the blue light-emitting layer is insufficient, resulting in a yellowish display at a low grayscale.

The inventors have found through researches that the pixel definition portion may be used to adjust light-emitting areas of different light-emitting layers to a certain extent, such as adjusting the area of the blue light-emitting layer to be slightly larger than the area of the yellow light-emitting layer, so as to adjust the display effect of the display substrate.

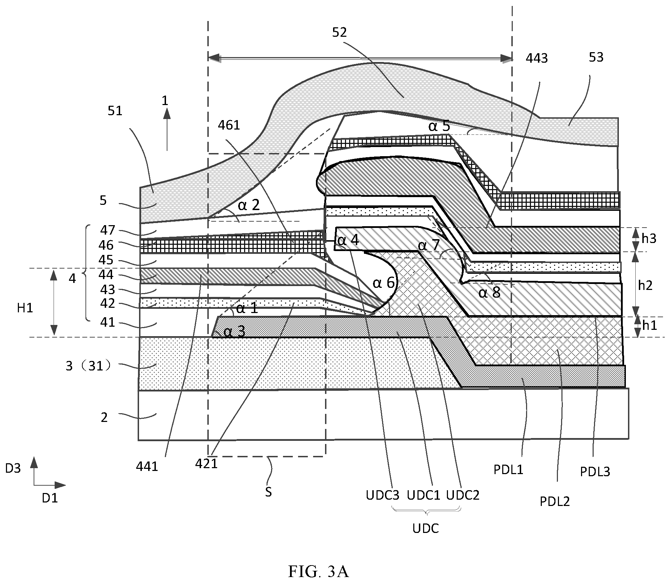

FIG. 3A shows a schematic cross-sectional view of the display substrate according to some embodiments of the present disclosure taken along line AA' of FIG. 1.

For example, in some embodiments of the present disclosure, referring to FIG. 3A, the display substrate further includes a second electrode layer 5 located on a side of the light-emitting functional layer 4 away from the base substrate. The second electrode layer includes a second electrode first sub-portion 51, a second electrode second sub-portion 52 and a second electrode third sub-portion 53. An orthographic projection of the second electrode first sub-portion 51 on the base substrate overlaps at least partially with an orthographic projection of the pixel opening on the base substrate. An orthographic projection of the second electrode second sub-portion 52 on the base substrate overlaps at least partially with an orthographic projection of the undercut structure UDC on the base substrate. An orthographic projection of the second electrode third sub-portion 53 on the base substrate overlaps at least partially with the orthographic projection of the pixel definition body portion on the base substrate. The second electrode layer 5 extends continuously at the undercut structure. For example, the second electrode first sub-portion 51 is located in a light-emitting region of the display substrate, the second electrode third sub-portion 53 is located in a non-light-emitting region of the display substrate, and the second electrode second sub-portion 52 is located at an intersection of the non-light-emitting region and the light-emitting region of the display substrate. Since an edge of the light-emitting region of the pixel unit is provided with the pixel definition portion, a film layer where the second electrode second sub-portion 52 is located may be uneven in that region.

For example, a virtual connecting line between an edge of the first portion UDC1 in a direction facing the pixel opening 1 and an edge of the third portion UDC3 in a direction facing the pixel opening 1 forms a first slope angle α1 with the first direction D1, and a side edge of the second electrode second sub-portion 52 in a direction facing the pixel opening 1 has a second slope angle α2. The first slope angle α1 is less than the second slope angle α2.

For example, in some embodiments of the present disclosure, referring to FIG. 3A, the first slope angle α1 is less than 30°.

For example, in some embodiments of the present disclosure, referring to FIG. 3A, a side edge of the second electrode second sub-portion 52 in a direction away from the pixel opening 1 has a fifth slope angle α5, which is less than the first slope angle α1.

For example, in some embodiments of the present disclosure, referring to FIG. 2, the second distance d2 is greater than twice the first distance d1.

Through the design of the undercut structure UDC in which the first slope angle in the undercut structure is controlled to be less than the second slope angle in the second electrode layer, it may be ensured that the second electrode layer may not break at the undercut structure UDC while ensuring that the charge generation layer is partitioned at the undercut structure UDC, thereby improving an in-plane uniformity of the display substrate. By controlling the fifth slope angle to be less than the first slope angle, it may be ensured that the film layer of the second electrode layer located above a region where a side of the lap portion away from the pixel opening is located may be smoother, which may help improve the uniformity of the electric field distribution and the in-plane uniformity of the display substrate.

For example, in some embodiments of the present disclosure, continuing to refer to FIG. 3A, an edge of a layer where the first portion UDC1 is located in a direction facing the pixel opening 1 has a third slope angle α3, and an edge of a layer where the third portion UDC3 is located in direction facing the pixel opening 1 has a fourth slope angle α4. The third slope angle α3 is less than the fourth slope angle α4.

For example, in some embodiments of the present disclosure, referring to FIG. 2 and FIG. 3A in combination, a side edge of the second portion UDC2 in a direction facing the pixel opening 1 has a sixth slope angle α6, a side edge of the lap portion PL12 in a direction away from the pixel opening 1 has a seventh slope angle α7, and a side edge of the pixel definition body portion PL11 in a direction facing the pixel opening 1 has an eighth slope angle α8. The sixth slope angle α6 is greater than the seventh slope angle α7; and/or the seventh slope angle α7 is greater than the first slope angle α1; and/or the first slope angle α1 is greater than the eighth slope angle α8.

By optimizing edge inclination angles of the pixel definition body portion and the lap portion in the pixel definition portion, the film layer of the second electrode layer at the undercut structure may be smoother, ensuring that second electrode layer may not break at the undercut structure, thereby improving the in-plane uniformity of the display substrate.

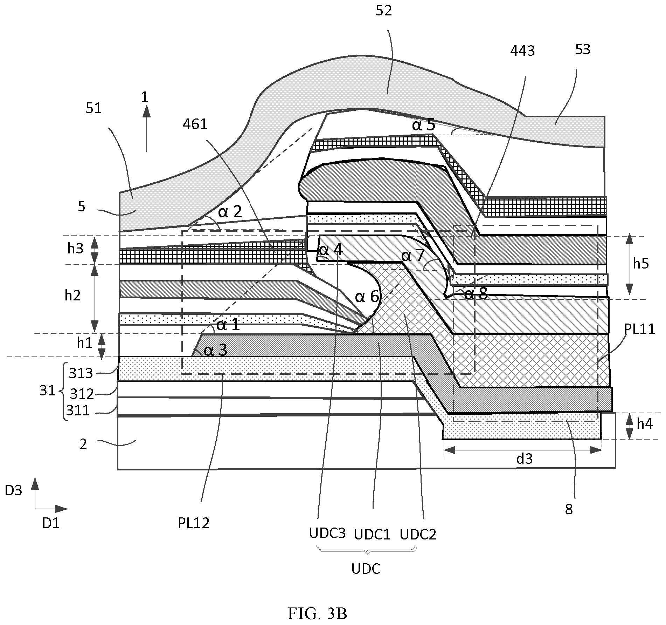

For example, in some embodiments of the present disclosure, the sub-pixel may include a stacked OLED device that is used to generate the white light under a control of an electric field. Referring to FIG. 3, the light-emitting functional layer 4 in the stacked OLED device may include a first light-emitting sub-layer 42 and a second light-emitting sub-layer 46. The first light-emitting sub-layer 42 is located between the first electrode layer 3 and the charge generation layer 44, and the second light-emitting sub-layer 46 is located on a side of the charge generation layer 44 away from the base substrate 2. The first light-emitting sub-layer 42 is used to generate light having a first wavelength, and the second light-emitting sub-layer 46 is used to generate light having a second wavelength. For example, the light having the first wavelength may include yellow light or red-green mixed light, and the light having the second wavelength may include blue light.

In some embodiments, the first light-emitting sub-layer may include a single film layer formed by a mixed evaporation of a host material and a yellow luminescent dye. Alternatively, the first light-emitting sub-layer may include a single film layer formed by a mixed evaporation of a plurality of materials including a host material, a green luminescent dye and a red luminescent dye. Alternatively, the first light-emitting sub-layer may include a plurality of light-emitting film layers, for example, the first light-emitting sub-layer may include a film layer formed by a mixed evaporation of a first host material and a green luminescent material and a film layer formed by a mixed evaporation of a second host material and a red luminescent material, and the first host material may be the same as or different from the second host material.

For example, the light-emitting functional layer 4 may further include a first hole functional layer 41, a first electron functional layer 43, a second hole functional layer 45, and a second electron functional layer 47. For example, the first hole functional layer 41 and the second hole functional layer 45 may include a plurality of film layers such as a hole injection layer, a hole transport layer and an electron blocking layer, etc., and the first electron functional layer 43 and the second electron functional layer 47 may include a plurality of film layers such as an electron injection layer, an electron transport layer and a hole blocking layer, etc.

For example, any two of an orthographic projection of the second light-emitting sub-layer 46 on the base substrate, an orthographic projection of the first charge generation sub-portion 441 on the base substrate and an orthographic projection of the first portion UDC1 of the undercut structure on the first side 111 of the pixel definition portion on the base substrate may overlap at least partially with each other. Since the first portion UDC1 is an insulation layer, a portion 421 of the first light-emitting sub-layer 42 in a range of a dashed box region S may not emit light due to an isolation of the insulation layer, while a portion 461 of the second light-emitting sub-layer 46 in a range of the region S may emit light, such as blue light, since both the first charge generation sub-portion 441 and the second electrode layer 5 are conductive. Due to the protruding design of the first portion UDC1, a light-emitting area of the second light-emitting sub-layer is slightly larger than a light-emitting area of the first light-emitting sub-layer in a same sub-pixel, so that the problem of insufficient luminous brightness of the second light-emitting sub-layer under a low voltage may be partially compensated. For example, when the second light-emitting sub-layer emits blue light, the luminous efficiency of blue light at a low voltage may be relatively increased, thereby improving the display effect of the display substrate at a low grayscale.

Similarly, referring to FIG. 2 and FIG. 3A in combination, any two of the orthographic projection of the second light-emitting sub-layer 46 on the base substrate, an orthographic projection of the second charge generation sub-portion 442 on the base substrate and the orthographic projection of the first portion UDC1 of the undercut structure on the second side 121 of the pixel definition portion on the base substrate may overlap at least partially with each other. Through the design that the first portion UDC1 of the pixel definition portion between pixel units protrudes relative to the second portion UDC2, the light-emitting area of the second light-emitting sub-layer located on an upper side of the charge generation layer may be slightly larger than the light-emitting area of the first light-emitting sub-layer located on a lower side of the charge generation layer in the same pixel unit, so that a light color of the OLED light-emitting device at a low grayscale may be adjusted and the display effect of the display substrate may be improved.

For example, in some embodiments of the present disclosure, continuing to refer to FIG. 3A, the second pixel definition sub-layer PDL2 has a second thickness h2 in the third direction D3, the third pixel definition sub-layer PDL3 has a third thickness h3 in the third direction D3, and a maximum distance between a surface of the first charge generation sub-portion 441 away from the base substrate and a surface of the first electrode layer 3 away from the base substrate is a first height H1. The third direction D3 is perpendicular to both the first direction D1 and the second direction D2. A sum of the second thickness h2 and the third thickness h3 is greater than the first height H1.

Through the design that a height from a portion of the charge generation layer located in the pixel opening region to the first electrode layer being less than the sum of the thicknesses of two upper pixel definition sub-layers in the pixel definition layer, a height difference may be formed between the charge generation layer located in the pixel opening region and the charge generation layer located above the pixel definition layer, so that the charge generation layer may be better partitioned at the undercut structure of the pixel definition layer, the lateral crosstalk between pixels and the electrical leakage in the display substrate may be reduced, which may help improve the transfer rate of the display substrate and improve the display effect of the display substrate.

For example, in some embodiments of the present disclosure, referring to FIG. 2 and FIG. 3A in combination, the second distance d2 is greater than a sum of the second thickness h2, the third thickness h3 and 0.5 times the first distance d1, i.e., d2>h2+h3+0.5*d1 ∘

For example, the sum of the second thickness h2, the third thickness h3 and 0.5 times the first distance d1 is greater than 1100 angstroms. Through the concave design of the second portion UDC2, an equivalent partition distance of the undercut structure may be increased, so as to ensure that the undercut structure may effectively partition the charge generation layer while reducing a physical thickness of the undercut structure. When the physical thickness of the undercut structure is reduced, the second electrode layer located above the undercut structure may be smoother, so as to ensure that the second electrode layer remains continuous at the undercut structure, which may help improve the in-plane uniformity of the display substrate.

In some embodiments, the larger the second thickness h2 of the second pixel definition sub-layer PDL2, the better the partitioning effect on the charge generation layer between pixels. However, a selection of the second thickness h2 also needs to take into account an influence on a spectrum of the stacked device. When the second thickness is larger, a distance between the first charge generation sub-portion 441 and the third charge generation sub-portion 443 is farther, and a function of the first charge generation sub-portion 441 in a distortion region (a region close to the undercut structure formed by a steep change of the film layer) may decrease. For example, the luminous effect of the second light-emitting sub-layer 461 in the range of the region S may be weakened, and intrinsic yellow light or green light of the OLED device may be lit up first, which may result in a yellowish display of the display substrate at a low grayscale.

For example, the second thickness h2 is greater than or equal to 300 angstroms and less than or equal to 600 angstroms; and/or the third thickness h3 is greater than or equal to 200 angstroms. By optimizing the second thickness h2 of the second pixel definition sub-layer PDL2, it is possible to maintain a control effect on the spectrum of the display substrate at a low grayscale while ensuring the effective partition of the charge generation layer. On one hand, the electrical leakage rate may be reduced, and the transfer rate of the display substrate may be improved, which may help improve the power consumption and life of the display substrate, and on the other hand, the spectrum of the display substrate may be controlled, and the display effect of the display substrate may be improved.

For example, in some embodiments of the present disclosure, referring to FIG. 2, the second portion UDC2 in the second pixel definition sub-layer recesses by the first distance d1 relative to the third portion UDC3 in the third pixel definition sub-layer in a direction away from the pixel opening, so that a pixel definition portion having an undercut structure is formed. A depth of the undercut structure may affect the partitioning effect of the pixel definition portion. Generally speaking, the greater the depth of the undercut structure, i.e., the first distance d1, the better the partitioning effect. However, the design of the first distance needs to further take into account a stability of the undercut structure itself and an influence of parameters such as etching rates of the materials of the second pixel definition sub-layer and the third pixel definition sub-layer.

For example, the undercut structure may be formed by a simultaneous etching process of the second pixel definition sub-layer PDL2 and the third pixel definition sub-layer PDL3. Due to limitations of etching rates and film support structures, the depth of the undercut structure may be affected by material properties and film thicknesses of the second pixel definition sub-layer PDL2 and the third pixel definition sub-layer PDL3. For example, when the second pixel definition sub-layer PDL2 contains SiNₓ and the third pixel definition sub-layer PDL3 contains SiOₓ, the first distance d1 is preferably greater than or equal to 400 angstroms and less than or equal to 600 angstroms. By optimizing the depth of the undercut structure, on one hand, a structural stability of the undercut structure may be ensured, and on the other hand, the partitioning effect of the pixel definition layer may be maximized to reduce the electrical leakage and improve the transfer rate of the display substrate. Due to the use of the undercut structure having two protruding ends and a concave middle, when the pixel definition portion partitions the charge generation layer, the distance that the second pixel definition sub-layer recesses is increased, so that the pixel definition layer requires a less height, thus the second electrode layer located above the pixel definition layer may be smoother, and the electric field distribution above the second electrode layer may be more uniform, which may help improve the in-plane uniformity of the display substrate.

FIG. 3B shows a schematic cross-sectional view of the display substrate according to some other embodiments of the present disclosure taken along line BB' of FIG. 1.

For example, in some embodiments of the present disclosure, referring to FIG. 3B, the display substrate further includes a plurality of third electrodes 8 electrically connected to the first electrodes 31. For example, the first electrode 31 may include a plurality of electrode sub-layers arranged in a stack, such as a first electrode first sub-layer 311, a first electrode second sub-layer 312 and a first electrode third sub-layer 313. The third electrode 8 may be located in the same layer as the first electrode third sub-layer 313. For example, the first electrode first sub-layer 311 may contain titanium, the first electrode second sub-layer 312 may contain silver, the first electrode third sub-layer 313 may contain ITO, and the third electrode 8 may contain ITO.

For example, referring to FIG. 2 and FIG. 3B in combination, an orthographic projection of the third electrode 8 on the base substrate overlaps at least partially with the orthographic projection of the pixel definition body portion PL11 on the base substrate, the third electrode 8 protrudes relative to the first electrode 31 in a direction toward the base substrate, the third electrode 8 protrudes a third distance d3 relative to the first electrode 31 in a direction away from the pixel opening 1, and the third distance d3 is greater than the second distance d2.

By providing the third electrode electrically connected to the first electrode at an edge of a gap between adjacent pixel openings, it is possible to balance an edge electric field of the pixel unit, reduce edge stray light of the pixel unit, improve the uniformity of the display unit, and improve the display effect of the display substrate.

For example, in some embodiments of the present disclosure, continuing to refer to FIG. 3B, the third electrode 8 has a fourth thickness h4 in the third direction D3, the first portion UDC1 has a first thickness h1 in the third direction, and the first thickness h1 is less than the fourth thickness h4. The layer where the first portion UDC1 is located is closer to the light-emitting region. By adjusting the first thickness h1 of the first portion UDC1 and the fourth thickness h4 of the third electrode 8, a transition of the electric field from the light-emitting region to the non-light-emitting region may be smoother, so that the uniformity of the pixel unit may be improved.

For example, in some embodiments of the present disclosure, continuing to refer to FIG. 3B, a side edge of the lap portion PL12 in a direction away from the pixel opening 1 has a fifth thickness h5, which is less than a sum of the first thickness h1, the second thickness h2 and the third thickness h3. By designing the side edge of the lap portion of the pixel definition portion away from the pixel opening as a slowly decreasing structure, the film layer of the second electrode layer located above the side edge of the lap portion away from the pixel opening may be smoother, and the second electrode layer located above an intersection of the lap portion and the pixel definition body portion may remain continuous, so that the in-plane uniformity of the display substrate may be improved.

For example, in some embodiments of the present disclosure, referring to FIG. 3B, the display substrate may include a second electrode layer 5 located on a side of the light-emitting functional layer 4 away from the base substrate. The second electrode layer includes a second electrode first sub-portion 51, a second electrode second sub-portion 52 and a second electrode third sub-portion 53. An orthographic projection of the second electrode first sub-portion 51 on the base substrate overlaps at least partially with the orthographic projection of the pixel opening on the base substrate. An orthographic projection of the second electrode second sub-portion 52 on the base substrate overlaps at least partially with the orthographic projection of the undercut structure UDC on the base substrate. An orthographic projection of the second electrode third sub-portion 53 on the base substrate overlaps at least partially with the orthographic projection of the pixel definition body portion PL11 on the base substrate. The second electrode layer 5 extends continuously at the undercut structure. A virtual connecting line between an edge of the first portion UDC1 in a direction facing the pixel opening 1 and an edge of the third portion UDC3 in a direction facing the pixel opening 1 forms a first slope angle α1 with the first direction D1, and a side edge of the second electrode second sub-portion 52 in a direction facing the pixel opening 1 has a second slope angle α2. The first slope angle α1 is less than the second slope angle α2.

Through the design of the undercut structure UDC, it may be ensured that the second electrode layer may not break at the undercut structure UDC while the charge generation layer is partitioned at the undercut structure, so that the in-plane uniformity of the display substrate may be improved.

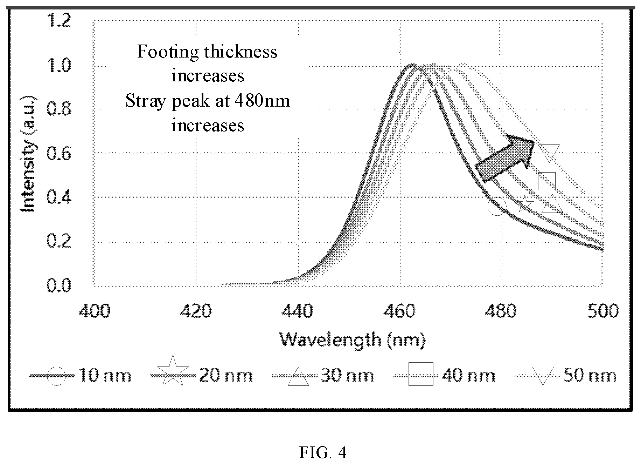

FIG. 4 shows a simulated relationship diagram of a blue light spectrum and the first thickness of the first portion of the display substrate according to some embodiments of the present disclosure.

For example, in some embodiments of the present disclosure, referring to FIG. 2 and FIG. 3A in combination, the first portion UDC1 located in the first pixel definition sub-layer protrudes the second distance d2 relative to the third portion UDC3 located in the third pixel definition sub-layer in a direction toward the pixel opening, so that the light-emitting area of the second light-emitting sub-layer 46 at a low grayscale may be increased to a certain extent, and the spectrum of the display substrate at the low grayscale may be adjusted to avoid a yellowish image quality at the low grayscale. Therefore, it is possible to control the display effect of the display substrate by adjusting a size of the second distance d2 that the first portion of the first pixel definition sub-portion protrudes relative to the third portion of the third pixel definition sub-portion in a direction toward the pixel opening.

The first pixel definition sub-layer has a first thickness h1 in the third direction. The first thickness h1 may affect the partitioning effect of the undercut structure of the pixel definition portion. For example, when the depth of the undercut structure is constant, if the first thickness h1 of the first pixel definition sub-layer increases, the distortion on an inner side of the third portion UDC3 may increase, resulting in a reduction of a low resistance effect of the second light-emitting sub-layer 46 and a weakening of the light emitted by the second light-emitting sub-layer. For example, FIG. 4 shows simulated blue light spectra of a plurality of display substrates having first portions with different thicknesses. Referring to FIG. 4, a horizontal axis represents the blue spectrum of the display substrate, a vertical axis represents a luminous intensity of blue light, and "footing" refers to the first portion UDC1 located in the first pixel definition sub-layer in the pixel definition layer. When the first thickness h1 of the first portion UDC1 increases, a stray peak of blue light around 480 nm may increase, and the brightness of the blue light decreases, which may thus affect the display effect of the display substrate.

The inventors found through researches that a result of an actual display substrate is consistent with the simulation result when the first thickness of the first portion increases. As the first thickness of the first portion increases, the stray peak of blue light around 480 nm increases, and the brightness of the blue light decreases.

Therefore, it is possible to adjust the luminous effect of the second light-emitting sub-layer by adjusting the first thickness h1 of the first pixel definition sub-layer, so as to affect the overall display effect of the display substrate.

For example, the second distance d2 is greater than 0.15 microns.

For example, the first thickness h1 of the first pixel definition sub-layer is greater than or equal to 200 angstroms and less than or equal to 300 angstroms.

By optimizing the first thickness of the first pixel definition sub-layer and the second distance that the first portion UDC1 in the first pixel definition sub-layer protrudes, the pixel definition portion may not only effectively partition the charge generation layer so as to avoid the electrical leakage, but also adjust the light-emitting area and luminous brightness of the second light-emitting layer relative to the first light-emitting layer, so that the yellowish display phenomenon of the display substrate at a low grayscale may be improved, and the display effect of the display substrate may be improved.

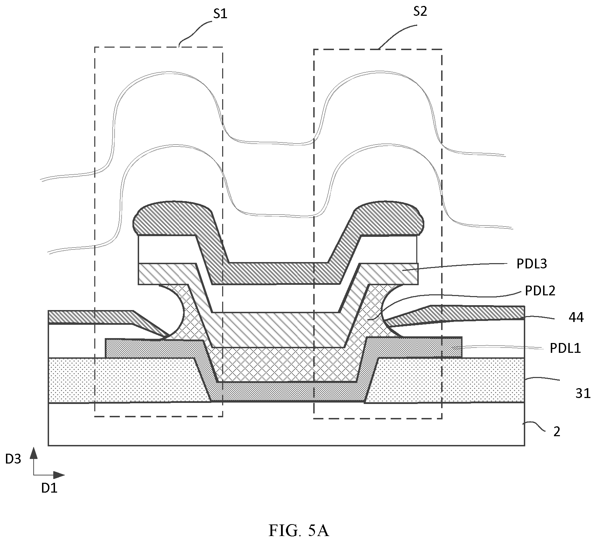

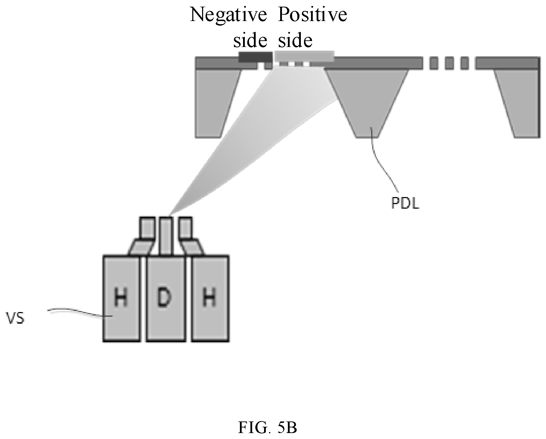

FIG. 5A and FIG. 5B respectively show schematic diagrams of an evaporation effect of the display substrate according to some embodiments of the present disclosure.

For example, in some embodiments of the present disclosure, an evaporation source is typically a point evaporation source in a manufacturing process of an OLED display substrate. Due to an occlusion of a pixel definition layer and a mask, during a process of evaporation, the pixel unit has a negative side and a positive side with respect to the point evaporation source, the positive side is less occluded, while the negative side is more occluded. Therefore, in a same evaporation process, film layers formed on the positive side and the negative side may have different thicknesses, and resulted distortion regions may also have different widths. For example, referring to FIG. 5A, the left side is the negative side S1, and the right side is the positive side S2, in the display substrate, after the pixel definition layer is manufactured, it is generally to further depositing, on the base substrate by using methods such as evaporation or sputtering, a plurality of organic film layers and inorganic film layers, such as an electron transport layer, a light-emitting functional layer, a charge generation layer, a hole transport layer, a cathode material layer and other film layers. A part of the film layers such as the charge generation layer may be disconnected at the undercut structure of the pixel definition portion, while a part of the film layers such as the cathode film layer may extend continuously at the undercut structure of the pixel definition portion. Due to the occlusion of the pixel definition portion, a plurality of film layers may be deposited with different topographies and thicknesses on two sides of the pixel definition portion. For example, referring to FIG. 5B, when evaporating the light-emitting functional layer, three organic sources VS including dual hosts H and a single doped dye D may be co-evaporated so as to form the light-emitting functional layer, and a film layer structure formed on the negative side is different from a film layer structure formed on the positive side due to the occlusion of the pixel definition portion PDL.

It should be noted that the light-emitting functional layer formed of dual hosts H and single doped dye D in the present disclosure is just illustrative, and a structure of the light-emitting functional layer is not limited in the present disclosure. The light-emitting functional layer of the present disclosure may adopt various doping structures known in the art, which is not particularly limited in the embodiments of the present disclosure.

For example, in some embodiments of the present disclosure, a distortion width of an inner side of the pixel definition portion on the negative side is greater than a distortion width of an inner side of the pixel definition portion on the positive side.

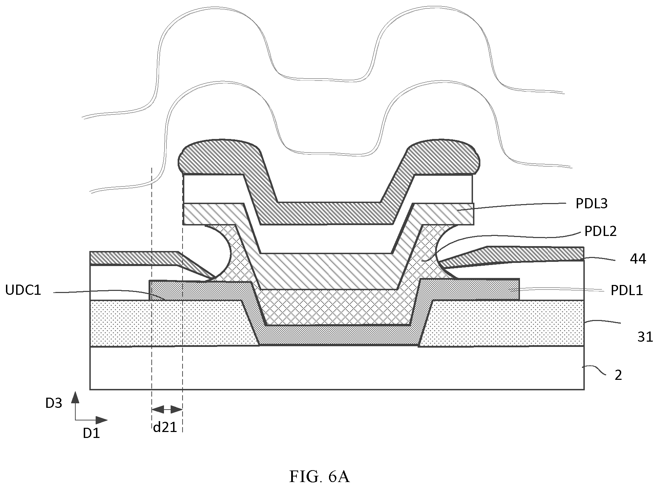

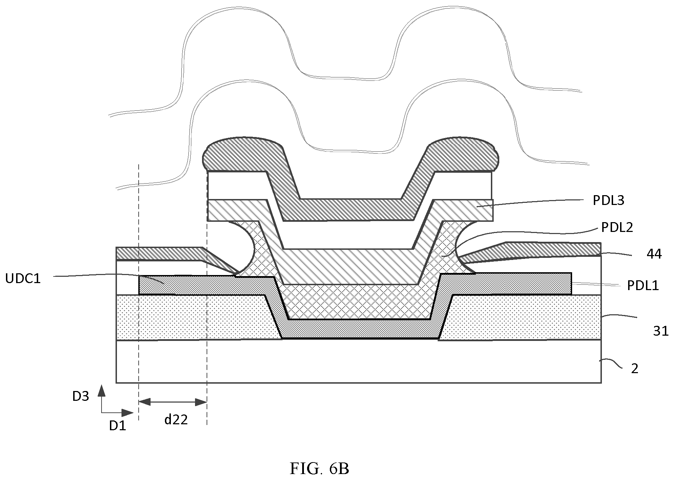

FIG. 6A and FIG. 6B respectively show comparison diagrams of distortions of display substrates according to some embodiments of the present disclosure.

For example, in some embodiments of the present disclosure, due to the occlusion of the pixel definition portion, each film layer in the light-emitting device has different distortions on the negative side and the positive side. A degree of distortion may be measured by a ratio of the distortion width of the inner side of the pixel definition portion to the height of the charge generation layer on the inner side of the pixel definition portion, and the larger the ratio, the more serious the distortion is, and the worse the display uniformity of the display substrate. Referring to FIG. 6A and FIG. 6B, in the pixel definition layers both having the undercut structure, the second distance d21 that the first portion UDC1 in the first pixel definition sub-layer protrudes in FIG. 6A is less than the second distance d22 that the first portion UDC1 in the first pixel definition sub-layer protrudes in FIG. 6B. By comparing the display substrate in FIG. 6A with the display substrate in FIG. 6B, it is possible to compare the effect of the second distance on the uniformity of the display substrate.

In some embodiments, in the display substrate shown in FIG. 6A, the distortion width on the left side (negative side) is 60 nm, the distortion width on the right side (the positive side) is 50 nm, and the height of the charge generation layer on the inner side of the pixel definition portion is 33 nm. A ratio of the distortion width on the left side to the height of the charge generation layer in FIG. 6A is 1.82, and a ratio of the distortion width on the right side to the height of the charge generation layer in FIG. 6A is 1.52. In the display substrate shown in FIG. 6B, the distortion width on the left side (negative side) is 90 nm, the distortion width on the right side (positive side) is 70 nm, and the height of the charge generation layer on the inner side of the pixel definition portion is 50 nm. A ratio of the distortion width on the left side to the height of the charge generation layer in FIG. 6B is 1.8, and a ratio of the distortion width on the right side to the height of the charge generation layer in FIG. 6B is 1.4. By comparing the display substrate in FIG. 6A with the display substrate in FIG. 6B, it may be found that an appropriate increase of the second distance may reduce the degree of distortion and improve the uniformity of the display substrate. For example, if the second distance d2 is greater than 0.15 microns, the distortion of each film layer of the pixel unit may be improved, and the consistency of the positive side and the negative side in a case of point source evaporation may be improved, which may help improve the in-plane uniformity of the display substrate.

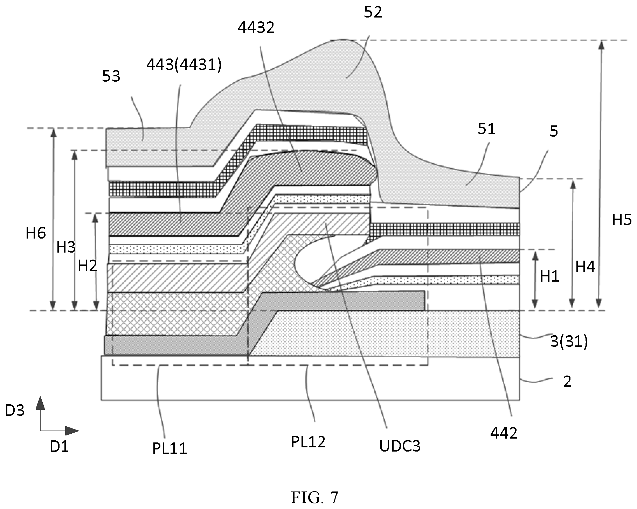

FIG. 7 shows a schematic cross-sectional view of the display substrate according to some other embodiments of the present disclosure taken along line CC' of FIG. 1.

For example, in some embodiments of the present disclosure, referring to FIG. 7, the third charge generation sub-portion 443 includes a first sub-portion 4431 and a second sub-portion 4432. An orthographic projection of the first sub-portion 4431 on the base substrate overlaps at least partially with the orthographic projection of the pixel definition body portion PL11 on the base substrate. An orthographic projection of the second sub-portion 4432 on the base substrate overlaps at least partially with either the orthographic projection of the lap portion PL12 on the base substrate or the orthographic projection of the third portion UDC3 on the base substrate.

In the third direction D3, a maximum distance between a surface of the first sub-portion 4431 away from the base substrate and the surface of the first electrode layer 3 away from the base substrate is a second height H2, and a maximum distance between a surface of the second sub-portion 4432 away from the base substrate and the surface of the first electrode layer 3 away from the base substrate is a third height H3. The third height H3 is greater than the second height H2.

For example, a maximum distance between a surface of the second charge generation sub-portion 442 away from the base substrate and the surface of the first electrode layer 3 away from the base substrate is a first height H1. The second height H2 is greater than the first height H1.

For example, a height difference between the third height H3 and the second height H2 is greater than a height difference between the second height H2 and the first height H1.

Through the design of the undercut structures on the two sides of the pixel definition portion, the charge generation layer may have different heights in different regions, so that a film layer breakage is formed and a purpose of lateral partition between pixels may be achieved, which may help reduce the electrical leakage, improve the transfer rate of the display substrate and improve the display effect of the display substrate.

For example, in some embodiments of the present disclosure, continuing to refer to FIG. 7, the display substrate includes a second electrode layer 5, which may be, for example, a whole surface cathode layer. The second electrode layer may be made of a transparent electrode film, such as an IZO film.

For example, continuing to refer to FIG. 7, the second electrode layer 5 may include a second electrode first sub-portion 51, a second electrode second sub-portion 52 and a second electrode third sub-portion 53. An orthographic projection of the second electrode first sub-portion 51 on the base substrate overlaps at least partially with an orthographic projection of the first electrode 31 on the base substrate. An orthographic projection of the second electrode second sub-portion 52 on the base substrate overlaps at least partially with an orthographic projection of the lap portion PL12 on the base substrate. An orthographic projection of the second electrode third sub-portion 53 on the base substrate overlaps at least partially with an orthographic projection of the pixel definition body portion PL11 on the base substrate.

In the third direction, a maximum distance between a surface of the second electrode first sub-portion 51 away from the base substrate and the surface of the first electrode layer 3 away from the base substrate is a fourth height H4, a maximum distance between a surface of the second electrode second sub-portion 52 away from the base substrate and the surface of the first electrode layer 3 away from the base substrate is a fifth height H5, and a maximum distance between a surface of the second electrode third sub-portion 53 away from the base substrate and the surface of the first electrode layer 3 away from the base substrate is a sixth height H6. The fifth height H5 is greater than the sixth height H6, and the sixth height H6 is greater than the fourth height H4.

A height difference between the fifth height H5 and the sixth height H6 is greater than a height difference between the sixth height H6 and the fourth height H4.

The film layer of the second electrode layer may exhibit a significant change at an edge of the pixel definition layer, and the greater the thickness of the pixel definition layer, the sharper the change in the film layer of the second electrode layer at the edge of the pixel definition layer, and the easier it is to form distortion so as to result in the electrical leakage or uneven electric field distribution, which may affect the display effect. By using the pixel definition portion with the undercut structure having two protruding ends and a concave middle, the pixel definition portion may have a small thickness while meeting the same partitioning effect on the charge generation layer, which may effectively mitigate the change in the film layer of the second electrode layer and help improve the uniformity of the electric field distribution of the second electrode layer, thereby improving the in-plane uniformity of the display substrate and improving the display effect.

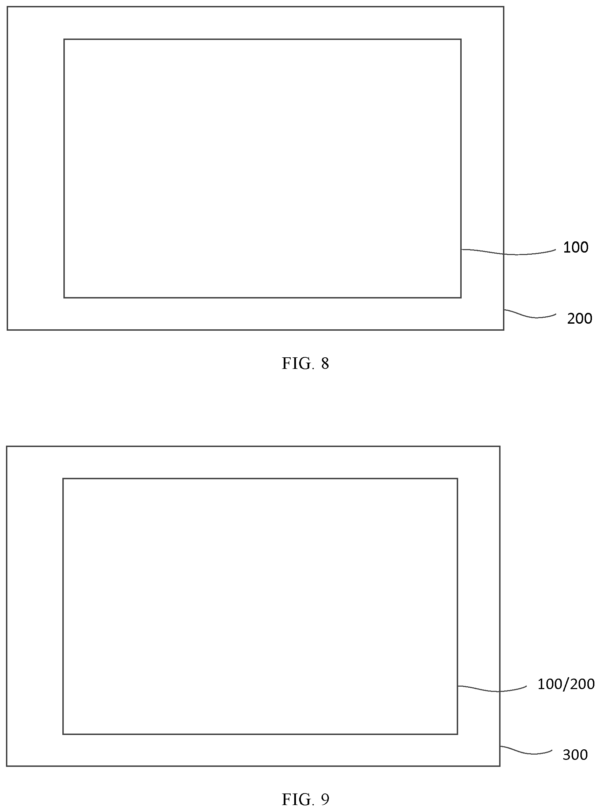

FIG. 8 shows a schematic structural diagram of a display panel provided according to some embodiments of the present disclosure.

Optionally, the embodiments of the present disclosure provide a display panel. Referring to FIG. 8, the display panel 200 may include the display substrate 100 mentioned above.

FIG. 9 shows a schematic structural diagram of a display device provided according to some embodiments of the present disclosure.

Optionally, the embodiments of the present disclosure further provide a display device. Referring to FIG. 9, the display device 300 may include the display substrate 100 mentioned above or the display panel 200 mentioned above. The display device may include but not be limited to an electronic paper, a mobile phone, a tablet computer, a display, a notebook computer, a digital photo frame, a navigator and any other product or component having a display function. It should be understood that the display device has the same beneficial effects as the display substrate provided in the foregoing embodiments.

Although some embodiments according to the general inventive concept of the present disclosure have been illustrated and explained, it may be understood by those skilled in the art that changes may be made to these embodiments without departing from the principles and spirit of the general inventive concept of the present disclosure, and the scope of the present disclosure is defined by the claims and their equivalents.

## Claims

1. A display substrate, comprising:
a base substrate;
a pixel definition layer provided on the base substrate, wherein the pixel definition layer has a plurality of pixel openings, the plurality of pixel openings define a plurality of sub-pixels arranged in an array in a first direction and a second direction, the pixel definition layer comprises a pixel definition portion located between two adjacent pixel openings, the pixel definition portion has an undercut structure on a side facing the pixel opening, the undercut structure comprises a first portion, a second portion and a third portion, the first portion is located on a side of the second portion close to the base substrate and protrudes a second distance relative to the third portion in a direction toward the pixel opening, the third portion is located on a side of the second portion away from the base substrate, and the second portion recesses a first distance relative to the third portion in a direction away from the pixel opening;
a light-emitting functional layer provided on a side of the pixel definition layer away from the base substrate, wherein the light-emitting functional layer comprises a charge generation layer; and
a second electrode layer provided on a side of the light-emitting functional layer away from the base substrate, wherein the second electrode layer comprises a second electrode second sub-portion, an orthographic projection of the second electrode second sub-portion on the base substrate overlaps at least partially with an orthographic projection of the undercut structure on the base substrate, and the second electrode layer extends continuously at the undercut structure,
wherein a virtual connecting line between an edge of the first portion in a direction facing the pixel opening and an edge of the third portion in a direction facing the pixel opening forms a first slope angle with the first direction, a side edge of the second electrode second sub-portion in a direction facing the pixel opening has a second slope angle, and the first slope angle is less than the second slope angle.

2. The display substrate of claim 1, wherein the first slope angle is less than 30°; and/or the second distance is greater than twice the first distance.

3. The display substrate of claim 2, wherein the edge of the first portion in the direction facing the pixel opening has a third slope angle, the edge of the third portion in the direction facing the pixel opening has a fourth slope angle, and the third slope angle is less than the fourth slope angle.

4. The display substrate of any one of claims 1 to 3, wherein a side edge of the second electrode second sub-portion in a direction away from the pixel opening has a fifth slope angle, and the fifth slope angle is less than the first slope angle.

5. The display substrate of any one of claims 1 to 4, wherein the pixel definition layer comprises a first pixel definition sub-layer, a second pixel definition sub-layer and a third pixel definition sub-layer sequentially stacked in a direction away from the base substrate; and
wherein the first portion is located in the first pixel definition sub-layer, the second portion is located in the second pixel definition sub-layer, and the third portion is located in the third pixel definition sub-layer.

6. The display substrate of any one of claims 1 to 5, wherein the display substrate further comprises a first electrode layer provided on a side of the pixel definition layer close to the base substrate;
wherein the display substrate comprises a plurality of first electrodes in the first electrode layer, the plurality of first electrodes are arranged in an array in the first direction and the second direction, and orthographic projections of the plurality of pixel openings on the base substrate fall within orthographic projections of the plurality of first electrodes on the base substrate, respectively; and
wherein the pixel definition portion further comprises a pixel definition body portion and a lap portion, an orthographic projection of the pixel definition body portion on the base substrate is located between orthographic projections of two adjacent first electrodes on the base substrate, an orthographic projection of the lap portion on the base substrate overlaps with the orthographic projection of the first electrode on the base substrate, and the lap portion protrudes relative to the pixel definition body portion in a direction away from the base substrate.

7. The display substrate of claim 6, wherein the display substrate further comprises a plurality of third electrodes electrically connected to the first electrodes, an orthographic projection of the third electrode on the base substrate overlaps at least partially with the orthographic projection of the pixel definition body portion on the base substrate, the third electrode protrudes relative to the first electrode in a direction close to the base substrate, the third electrode protrudes a third distance relative to the first electrode in the direction away from the pixel opening, and the third distance is greater than the second distance.

8. The display substrate of claim 7, wherein a side edge of the second portion in a direction facing the pixel opening has a sixth slope angle, a side edge of the lap portion in a direction away from the pixel opening has a seventh slope angle, and a side edge of the pixel definition body portion in a direction facing the pixel opening has an eighth slope angle;
wherein the sixth slope angle is greater than the seventh slope angle; and/or
the seventh slope angle is greater than the first slope angle; and/or
the first slope angle is greater than the eighth slope angle.

9. The display substrate of any one of claims 6 to 8, wherein the first portion, the second portion and the third portion are located on a side of the lap portion facing the pixel opening, and a surface of the second portion facing the pixel opening is a curved surface concave toward the pixel definition body portion.

10. The display substrate of any one of claims 1 to 9, wherein the plurality of sub-pixels comprise a first sub-pixel and a second sub-pixel adjacent to each other in the first direction or the second direction, the first sub-pixel comprises a first pixel opening, and the second sub-pixel comprises a second pixel opening; and
wherein the pixel definition portion comprises a pixel definition portion located between the first pixel opening and the second pixel opening, the pixel definition portion has undercut structures on a first side facing the first pixel opening and a second side facing the second pixel opening, and the charge generation layer is disconnected at the undercut structures.

11. The display substrate of claim 10, wherein the display substrate comprises a first charge generation sub-portion, a second charge generation sub-portion and a third charge generation sub-portion in the charge generation layer, an orthographic projection of the first charge generation sub-portion on the base substrate overlaps at least partially with an orthographic projection of the first pixel opening on the base substrate, an orthographic projection of the second charge generation sub-portion on the base substrate overlaps at least partially with an orthographic projection of the second pixel opening on the base substrate, and an orthographic projection of the third charge generation sub-portion on the base substrate overlaps at least partially with an orthographic projection of the pixel definition portion on the base substrate; and
wherein the first charge generation sub-portion is disconnected from the third charge generation sub-portion at the undercut structure on the first side of the pixel definition portion, and the second charge generation sub-portion is disconnected from the third charge generation sub-portion at the undercut structure on the second side of the pixel definition portion.

12. The display substrate of claim 6, wherein the light-emitting functional layer comprises a first light-emitting sub-layer and a second light-emitting sub-layer, the first light-emitting sub-layer is located between the first electrode layer and the charge generation layer, and the second light-emitting sub-layer is located on a side of the charge generation layer away from the base substrate;
wherein the first light-emitting sub-layer is configured to generate light having a first wavelength, and the second light-emitting sub-layer is configured to generate light having a second wavelength; and
wherein the light having the first wavelength comprises yellow light or red-green mixed light; and/or the light having the second wavelength comprises blue light.

13. The display substrate of claim 12, wherein any two of an orthographic projection of the second light-emitting sub-layer on the base substrate, an orthographic projection of the first charge generation sub-portion on the base substrate and an orthographic projection of the first portion of the undercut structure on the first side of the pixel definition portion on the base substrate overlap at least partially with each other; and/or
wherein any two of the orthographic projection of the second light-emitting sub-layer on the base substrate, an orthographic projection of the second charge generation sub-portion on the base substrate and an orthographic projection of the first portion of the undercut structure on the second side of the pixel definition portion on the base substrate overlap at least partially with each other.

14. The display substrate of claim 11, wherein the second pixel definition sub-layer has a second thickness in a third direction, the third pixel definition sub-layer has a third thickness in the third direction, a maximum distance between a surface of the first charge generation sub-portion away from the base substrate or a surface of the second charge generation sub-portion away from the base substrate and a surface of the first electrode layer away from the base substrate is a first height, the third direction is perpendicular to the first direction and the second direction, and a sum of the second thickness and the third thickness is greater than the first height.

15. The display substrate of claim 14, wherein the second distance is greater than a sum of the second thickness, the third thickness and 0.5 times the first distance, and the sum of the second thickness, the third thickness and 0.5 times the first distance is greater than 1100 angstroms.

16. The display substrate of any one of claims 1 to 15, wherein the first distance is greater than or equal to 400 angstroms and less than or equal to 600 angstroms.

17. The display substrate of claim 14 or 15, wherein the second thickness is greater than or equal to 300 angstroms and less than or equal to 600 angstroms; and/or
wherein the third thickness is greater than or equal to 200 angstroms.

18. The display substrate of any one of claims 5 to 17, wherein the first pixel definition sub-layer has a first thickness in a third direction, and the first thickness is greater than or equal to 200 angstroms and less than or equal to 300 angstroms.

19. The display substrate of claim 18, wherein the third electrode has a fourth thickness in the third direction, and the first thickness is less than the fourth thickness.

20. The display substrate of claim 18 or 19, wherein a side edge of the lap portion in a direction away from the pixel opening has a fifth thickness, and the fifth thickness is less than a sum of the first thickness, the second thickness and the third thickness.

21. The display substrate of any one of claims 2 to 20, wherein the second distance is greater than 0.15 microns.

22. The display substrate of claim 11, wherein the third charge generation sub-portion comprises a first sub-portion and a second sub-portion, an orthographic projection of the first sub-portion on the base substrate overlaps at least partially with an orthographic projection of the pixel definition body portion on the base substrate, and an orthographic projection of the second sub-portion on the base substrate overlaps at least partially with either an orthographic projection of the lap portion on the base substrate or an orthographic projection of the third portion on the base substrate; and
wherein in a third direction, a maximum distance between a surface of the first sub-portion away from the base substrate and a surface of the first electrode layer away from the base substrate is a second height, a maximum distance between a surface of the second sub-portion away from the base substrate and the surface of the first electrode layer away from the base substrate is a third height, and the third height is greater than the second height.

23. The display substrate of claim 22, wherein the second height is greater than a first height, and a height difference between the third height and the second height is greater than a height difference between the second height and the first height.

24. The display substrate of claim 1, wherein the second electrode layer further comprises a second electrode first sub-portion and a second electrode third sub-portion, an orthographic projection of the second electrode first sub-portion on the base substrate overlaps at least partially with an orthographic projection of a first electrode on the base substrate, an orthographic projection of the second electrode second sub-portion on the base substrate overlaps at least partially with an orthographic projection of a lap portion on the base substrate, and an orthographic projection of the second electrode third sub-portion on the base substrate overlaps at least partially with an orthographic projection of a pixel definition body portion on the base substrate; and
wherein in a third direction, a maximum distance between a surface of the second electrode first sub-portion away from the base substrate and a surface of a first electrode layer away from the base substrate is a fourth height, a maximum distance between a surface of the second electrode second sub-portion away from the base substrate and the surface of the first electrode layer away from the base substrate is a fifth height, a maximum distance between a surface of the second electrode third sub-portion away from the base substrate and the surface of the first electrode layer away from the base substrate is a sixth height, the fifth height is greater than the sixth height, and the sixth height is greater than the fourth height.

25. The display substrate of claim 24, wherein a height difference between the fifth height and the sixth height is greater than a height difference between the sixth height and the fourth height.

26. The display substrate of any one of claims 5 to 25, wherein the first pixel definition sub-layer comprises SiOₓ; and/or
the second pixel definition sub-layer comprises SiNₓ; and/or
the third pixel definition sub-layer comprises SiOₓ; and/or
the second electrode layer comprises IZO.

27. A display panel, comprising the display substrate of any one of claims 1 to 26.

28. A display device, comprising the display substrate of any one of claims 1 to 26 or the display panel of claim 27.
